(19) **Europäisches Patentamt**
**European Patent Office**
**Office européen des brevets**

(11) **EP 3 961 239 B1**

(12) **FASCICULE DE BREVET EUROPEEN**

(45) Date de publication et mention
de la délivrance du brevet:
**18.01.2023 Bulletin 2023/03**

(51) Classification Internationale des Brevets (IPC):
**G01R 35/04** *(2006.01)* **G01R 22/10** *(2006.01)*

(21) Numéro de dépôt: **21188726.0**

(52) Classification Coopérative des Brevets (CPC):
**G01R 35/04; G01R 22/10**

(22) Date de dépôt: **30.07.2021**

(54) **VERIFICATION DE LA PRECISION DES MESURES REALISEES PAR UN COMPTEUR ELECTRIQUE**

ÜBERPRÜFUNG DER GENAUIGKEIT DER VON EINEM STROMZÄHLER VORGENOMMENEN MESSUNGEN

VERIFICATION OF THE PRECISION OF THE MEASUREMENTS TAKEN BY AN ELECTRICITY METER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.08.2020 FR 2008760**

(43) Date de publication de la demande:
**02.03.2022 Bulletin 2022/09**

(73) Titulaire: **Sagemcom Energy & Telecom SAS 92500 Rueil-Malmaison (FR)**

(72) Inventeurs:
• **TEBOULLE, Henri**
**92500 Rueil Malmaison (FR)**
• **GRINCOURT, Christophe**
**92500 Rueil Malmaison (FR)**

(74) Mandataire: **Lavaud, Thomas et al**
**Cabinet Boettcher**
**16, rue Médéric**
**75017 Paris (FR)**

(56) Documents cités:
**EP-A1- 2 343 561     EP-A1- 3 026 447**

## Description

L'invention concerne le domaine des compteurs électriques communicants.

### ARRIERE PLAN DE L'INVENTION

Un compteur électrique moderne, aussi appelé « compteur électrique communicant », a pour fonction principale de mesurer l'énergie électrique consommée par l'installation électrique d'un client, mais est aussi capable de réaliser un certain nombre de fonctions complémentaires : gestion des tarifs par réception d'ordres, relève et programmation à distance, télé-information client, etc.

Pour mesurer l'énergie consommée, le compteur comporte un dispositif de mesure qui comprend très classiquement un ou des capteurs de courant et un ou des capteurs de tension.

Il est bien sûr indispensable que la précision du dispositif de mesure du compteur demeure conforme, au cours du temps, aux exigences de précision définies dans les spécifications fonctionnelles sur la base desquelles ledit dispositif de mesure a été conçu. En effet, une dérive du dispositif de mesure peut conduire soit à une surestimation de la consommation, qui est désavantageuse pour le client, soit à une sous-estimation de la consommation, qui est désavantageuse pour le fournisseur d'énergie électrique.

Or, les capteurs ont tendance à dériver dans le temps, et il est relativement complexe d'évaluer de manière fiable l'évolution de la précision du dispositif de mesure d'un compteur électrique. Il est bien sûr possible de faire intervenir un opérateur sur l'installation électrique pour vérifier la précision des mesures, mais cela n'est pas souhaitable, car une telle intervention est coûteuse et risque de déranger le client. Un état de la technique pertinent est divulgué dans le document EP2343561.

### OBJET DE L'INVENTION

L'invention a pour objet d'évaluer de manière précise et fiable la précision des mesures réalisées par le dispositif de mesure d'un compteur électrique, sans faire intervenir un opérateur.

### RESUME DE L'INVENTION

En vue de la réalisation de ce but, on propose un procédé d'évaluation de la précision d'un dispositif de mesure d'un compteur électrique, le procédé d'évaluation étant mis en œuvre par et dans le compteur électrique et comportant :

- une phase préliminaire, comprenant les étapes d'acquérir des premières mesures d'une première grandeur électrique, et de détecter une période de stabilité au cours de laquelle la première grandeur électrique est stable ;
- une phase de test, suivant la détection de la période de stabilité et comprenant les étapes d'injecter un courant de test pendant une durée prédéterminée sur un conducteur du compteur électrique, et d'acquérir pendant l'étape d'injection au moins une deuxième mesure de la première grandeur électrique ;
- une phase d'évaluation, comprenant les étapes de comparer la deuxième mesure de la première grandeur électrique avec une somme d'une première valeur de stabilité représentative de la première grandeur électrique au cours de la période de stabilité, et d'une valeur prédéfinie correspondant à une hausse attendue de la première grandeur électrique due à l'injection du courant de test, et d'évaluer la précision du dispositif de mesure à partir de ladite comparaison.

Le procédé d'évaluation selon l'invention est mis en œuvre par et dans le compteur électrique lui-même, et permet donc de vérifier la précision du dispositif de mesure du compteur électrique de manière automatique, sans nécessiter d'intervention humaine sur le compteur électrique.

Les caractéristiques connues du courant de test, qui est injecté sur le conducteur (de neutre ou de phase) du compteur électrique suite à la détection de la période de stabilité de la première grandeur électrique, permettent de définir une hausse attendue de la première grandeur électrique, qui est mesurée par le dispositif de mesure. Cette hausse attendue constitue une référence grâce à laquelle la précision du dispositif de mesure peut être évaluée et vérifiée de manière précise et fiable.

On propose de plus un procédé d'évaluation tel que précédemment décrit, dans lequel la valeur prédéfinie est évaluée à partir de la durée prédéterminée, d'une amplitude et d'une fréquence du courant de test.

On propose de plus un procédé d'évaluation tel que précédemment décrit, dans lequel la période de stabilité est détectée lorsqu'au moins une première condition de stabilité est vérifiée, selon laquelle un nombre prédéterminé de premières mesures successives de la première grandeur électrique sont sensiblement égales.

On propose de plus un procédé d'évaluation tel que précédemment décrit, comprenant en outre une phase de vérification, destinée à vérifier qu'une différence entre la deuxième mesure de la première grandeur électrique et la première valeur de stabilité est due uniquement à l'injection du courant de test.

On propose de plus un procédé d'évaluation tel que précédemment décrit, dans lequel la phase de vérification est réalisée suite à l'étape d'injection, et comprend les étapes d'acquérir une troisième mesure de la première grandeur électrique, et de vérifier au moins une première condition de vérification, selon laquelle la troisième mesure de la première grandeur électrique est sensiblement égale à la première valeur de stabilité.

On propose de plus un procédé d'évaluation tel que précédemment décrit, dans lequel la première grandeur électrique est une énergie consommée pendant une durée prédéfinie.

On propose de plus un procédé d'évaluation tel que précédemment décrit, dans lequel la phase préliminaire comprend aussi les étapes d'acquérir des premières mesures d'une deuxième grandeur électrique.

On propose de plus un procédé d'évaluation tel que précédemment décrit, dans lequel la période de stabilité est détectée lorsque la première grandeur électrique et la deuxième grandeur électrique sont stables.

On propose de plus un procédé d'évaluation tel que précédemment décrit, dans lequel la phase de stabilité est détectée lorsque la première condition de stabilité est vérifiée, et lorsqu'une deuxième condition de stabilité est vérifiée, selon laquelle un même nombre prédéterminé de premières mesures successives de la deuxième grandeur électrique sont sensiblement égales.

On propose de plus un procédé d'évaluation tel que précédemment décrit, dans lequel la phase de confirmation comprend aussi les étapes d'acquérir une deuxième mesure de la deuxième grandeur électrique, et de vérifier la première condition de vérification et une deuxième condition de vérification, selon laquelle la deuxième mesure de la deuxième grandeur électrique est sensiblement égale à une deuxième valeur de stabilité représentative d'une valeur de la deuxième grandeur électrique au cours de la période de stabilité.

On propose de plus un procédé d'évaluation tel que précédemment décrit, dans lequel la deuxième grandeur électrique est un courant.

On propose de plus un procédé d'évaluation tel que précédemment décrit, dans lequel une fréquence du courant de test est définie de sorte que ladite fréquence est comprise dans une bande de fréquence opérationnelle du dispositif de mesure tout en étant à l'extérieur d'une bande de fréquence utilisée pour une communication par courants porteurs en ligne mise en œuvre par le compteur électrique.

On propose de plus un procédé d'évaluation tel que précédemment décrit, dans lequel une amplitude crête du courant de test est comprise entre 800mA et 1.2A, et dans lequel une fréquence du courant de test est comprise entre 1.6kHz et 2.4kHz.

On propose en outre un compteur électrique comportant un dispositif de mesure, un dispositif d'injection comprenant un générateur de courant, et un module de traitement agencé pour mettre en œuvre le procédé d'évaluation précédemment décrit.

On propose en outre un compteur électrique tel que précédemment décrit, dans lequel le générateur de courant est un miroir de courant intégrant un oscillateur réglé à une fréquence du courant de test.

On propose en outre un compteur électrique tel que précédemment décrit, dans lequel le générateur de courant est relié au conducteur via une inductance et un interrupteur piloté par le module de traitement.

On propose en outre un compteur électrique tel que précédemment décrit, dans lequel une valeur de l'inductance est comprise entre 64μH et 96μH.

On propose aussi un programme d'ordinateur comprenant des instructions qui conduisent le compteur électrique tel que précédemment décrit à exécuter les étapes du procédé d'évaluation qui vient d'être décrit.

On propose aussi un support d'enregistrement lisible par ordinateur, sur lequel est enregistré le programme d'ordinateur qui vient d'être décrit.

L'invention sera mieux comprise à la lumière de la description qui suit d'un mode de mise en œuvre particulier non limitatif de l'invention.

BREVE DESCRIPTION DU DESSIN

Il sera fait référence à la figure unique :

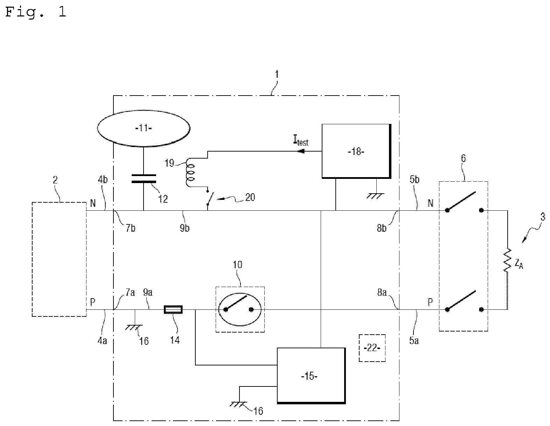

[Fig. 1] la figure 1 représente un compteur électrique dans lequel est mis en œuvre le procédé d'évaluation selon l'invention.

DESCRIPTION DETAILLEE DE L'INVENTION

En référence à la figure 1, le procédé d'évaluation selon l'invention est ici mis en œuvre par et dans un compteur électrique monophasé 1.

Le compteur 1 est utilisé pour mesurer une énergie électrique fournie par un réseau de distribution électrique 2 et consommée par une installation électrique 3 (symbolisée par une charge $Z_A$). Le réseau 2 comporte une ligne électrique comprenant un conducteur de phase 4a et un conducteur de neutre 4b. La tension du réseau 2 est une tension alternative de fréquence égale à 50Hz et de tension efficace égale à 230V. L'installation 3 reçoit l'énergie électrique par un conducteur de phase 5a et un conducteur de neutre 5b.

Un disjoncteur 6 est positionné en aval du compteur 1 et en amont de l'installation 3, pour pouvoir isoler l'installation 3 du réseau 2 lorsque cela est nécessaire.

Ici, par « en amont », on entend du côté du réseau 2, et par « en aval », on entend du côté de l'installation 3.

Le compteur 1 comporte une borne de phase amont 7a, une borne de phase aval 8a, une borne de neutre amont 7b et une borne de neutre aval 8b.

La borne de phase amont 7a est connectée au conducteur de phase 4a du réseau 2. La borne de phase aval 8a est connectée au conducteur de phase 5a de l'installation 3. La borne de neutre amont 7b est connectée au conducteur de neutre 4b du réseau 2. La borne de neutre aval 8b est connectée au conducteur de neutre 5b de l'installation 3.

Le compteur 1 comporte aussi un conducteur de phase 9a, connecté à la borne de phase amont 7a et à la borne de phase aval 8a, et un conducteur de neutre 9b, connecté à la borne de neutre amont 7b et à la borne de neutre aval 8b.

Le compteur 1 comporte de plus un organe de coupure 10 (*breaker*) monté sur le conducteur de phase 9a entre la borne de phase amont 7a et la borne de phase aval 8a. L'organe de coupure 10 permet de sélectivement connecter et déconnecter, à distance, l'installation 3 du réseau 2.

Le compteur 1 comporte de plus un modem 11 qui permet au compteur 1 de mettre en œuvre une communication par courants porteurs en ligne (CPL). Le modem 11 est ici un modem du type modem CPL G3. Le compteur 1 peut ainsi communiquer avec le Système d'Information (SI) du gestionnaire du réseau (éventuellement via une autre entité, telle qu'un concentrateur de données, une passerelle, un autre compteur, etc.).

Le modem 11 est connecté au conducteur de neutre 9b du compteur 1 via une capacité 12.

Le compteur 1 comporte de plus un dispositif de mesure. Le dispositif de mesure réalise les mesures de l'énergie consommée par l'installation 3, et est donc utilisé pour mettre en œuvre la fonction principale du compteur 1.

Le dispositif de mesure comprend un capteur de tension (non représenté), un capteur de courant 14, et un module de mesure 15.

Le capteur de tension produit des mesures de la tension entre le conducteur de phase 9a et le conducteur de neutre 9b du compteur 1.

Le capteur de courant 14 est un *shunt* qui est monté sur le conducteur de phase 9a du compteur 1 entre la borne de phase amont 7a et l'organe de coupure 10.

Le module de mesure 15 est relié au conducteur de phase 9a du compteur 1, entre le *shunt* et l'organe de coupure 10. Le module de mesure 15 est aussi relié au conducteur de neutre 9b du compteur 1. Le module de mesure 15 est de plus relié à la masse électrique 16 du compteur 1. Le module de mesure 15 acquiert les mesures (analogiques) réalisés par le capteur de tension et par le capteur de courant 14 et produit des mesures (numériques) de courant et de l'énergie consommée par l'installation 3.

Le conducteur de phase 9a du compteur 1 est relié à la masse électrique 16 du compteur 1 en amont du *shunt.*

Le compteur 1 comporte de plus un dispositif d'injection de courant, qui est agencé pour injecter un courant de test $I_{test}$ aux caractéristiques connues et maîtrisées sur le conducteur de neutre 9b du compteur 1. Le dispositif d'injection comprend un générateur de courant 18, une inductance 19 et un interrupteur 20. L'inductance 19 et l'interrupteur 20 sont montés en série.

Comme on le verra plus bas, l'invention consiste notamment à injecter le courant de test $I_{test}$ sur le conducteur de neutre 9b du compteur 1, à effectuer pendant l'injection des mesures grâce au dispositif de mesure, et à utiliser le courant de test $I_{test}$ comme référence pour vérifier la précision du dispositif de mesure. L'injection est réalisée sur le conducteur de neutre 9b en amont d'un point auquel est connecté le module de mesure 15.

Le générateur de courant 18 permet de générer le courant de test $I_{test}$, qui est un courant alternatif (ici sinusoïdal).

Le courant de test $I_{test}$ a une amplitude crête qui est comprise par exemple entre 800mA et 1,2A. Ici, l'amplitude crête du courant de test $I_{test}$ est égale à 1A.

La fréquence du courant de test $I_{test}$ est comprise par exemple entre 1,6kHz et 2,4kHz. Ici, la fréquence du courant de test $I_{test}$ est égale à 2kHz.

On note que la valeur de 1A de l'amplitude crête et la valeur de 2kHz de la fréquence sont paramétrables.

La fréquence du courant de test $I_{test}$ a été définie selon (au moins) deux critères.

Le premier critère est que ladite fréquence soit comprise dans la bande de fréquence opérationnelle du dispositif de mesure, c'est-à-dire dans la bande de fréquence dans laquelle le dispositif de mesure est capable de réaliser des mesures avec une précision nominale.

Ainsi, les effets du courant de test $I_{test}$ peuvent être mesurés précisément via le dispositif de mesure. Ici, la quarantième harmonique du 50Hz est mesurable sans problème par le dispositif de mesure, de sorte que la fréquence de 2kHz est parfaitement adaptée.

Le deuxième critère est que la fréquence du courant de test $I_{test}$ soit à l'extérieur de la bande de fréquence utilisée pour la communication CPL. Ainsi, l'injection du courant de test $I_{test}$ ne perturbe pas la communication CPL.

Le générateur de courant 18 est par exemple un miroir de courant intégrant un oscillateur réglé à la fréquence du courant de test $I_{test}$, c'est-à-dire ici à 2kHz.

Une sortie du générateur de courant 18 est reliée au conducteur de neutre 9b via l'inductance 19 et l'interrupteur 20.

La valeur de la fréquence du courant de test $I_{test}$ permet d'utiliser une inductance 19 n'ayant pas une valeur trop élevée.

La valeur de l'inductance 19 est par exemple comprise entre 64µH et 96µH. Ici, la valeur de l'inductance est égale à 80µH.

Le compteur 1 comporte de plus un module de traitement 22.

Le module de traitement 22 comprend par exemple un processeur, un microcontrôleur, ou bien un circuit logique programmable tel qu'un FPGA (pour *Field Programmable Gate Arrays*) ou un ASIC (pour *Application Specific Integrated Circuit*).

Le module de traitement 22 est relié au module de mesure 15 pour acquérir les mesures réalisées par le dispositif de mesure. Le module de traitement 22 est notamment agencé pour piloter l'interrupteur 20 et le générateur de courant 18 (le module de traitement 22 peut par exemple paramétrer si nécessaire l'amplitude crête et la fréquence du courant de test). Le module de traitement 22 est aussi relié au modem 11.

On décrit maintenant le procédé d'évaluation selon l'invention, qui est mis en œuvre par le module de traitement 22 du compteur 1.

A intervalles réguliers, la précision du dispositif de mesure du compteur 1 est évaluée. L'évaluation est faite par exemple avec une périodicité mensuelle.

Le dispositif de mesure produit des mesures du courant fourni à l'installation et des mesures d'énergie consommée pendant une durée prédéfinie. Ici, la durée prédéfinie est égale à une seconde. Chaque seconde, le dispositif de mesure produit une mesure de courant et une mesure d'énergie consommée au cours de la seconde précédente.

Lorsqu'il convient d'évaluer la précision du dispositif de mesure, une phase préliminaire débute, au cours de laquelle le module de traitement 22 acquiert des premières mesures d'une première grandeur électrique et des premières mesures d'une deuxième grandeur électrique, réalisées par le dispositif de mesure. La première grandeur électrique est l'énergie consommée pendant la durée prédéfinie (une seconde), et la deuxième grandeur électrique est le courant.

On parlera de mesures d'énergie et de mesures de courant pour simplifier la description : le module de traitement 22 acquiert donc au cours de la phase préliminaire des premières mesures d'énergie et des premières mesures de courant.

Au cours de la phase préliminaire, le module de traitement 22 tente de détecter une période de stabilité, au cours de laquelle l'énergie consommée et le courant sont stables.

La période de stabilité est détectée lorsqu'une première condition de stabilité est vérifiée, selon laquelle un nombre prédéterminé de premières mesures successives d'énergie sont sensiblement égales, et lorsqu'une deuxième condition de stabilité est vérifiée, selon laquelle un même nombre prédéterminé de premières mesures successives de courant sont sensiblement égales.

Le nombre prédéterminé est ici égal à deux.

Ainsi, dès que le module de traitement 22 détecte deux premières mesures successives d'énergie sensiblement égales, réalisées chacun à une seconde d'intervalle, et que les deux premières mesures successives de courant associées sont elles aussi sensiblement égales, le module de traitement 22 détecte une phase de stabilité.

Par « deux mesures sensiblement égales », on entend ici que les deux mesures sont égales, à la précision du dispositif de mesure près.

Le composant de traitement détermine une première valeur de stabilité et une deuxième valeur de stabilité. La première valeur de stabilité est représentative de l'énergie consommée pendant la durée prédéfinie au cours de la période de stabilité, et est égale aux premières mesures d'énergie de la période de stabilité. La deuxième valeur de stabilité est représentative du courant au cours de la période de stabilité, et est égale aux premières mesures de courant de la période de stabilité.

Suite à la détection de la période de stabilité, le module de traitement 22 démarre une phase de test. Le module de traitement 22 ferme l'interrupteur 20 et fait ainsi injecter par le générateur de courant 18 pendant une durée prédéterminée le courant de test $I_{test}$ sur le conducteur de neutre 9b du compteur 1. La durée prédéterminée est ici égale à la durée prédéfinie, c'est-à-dire à une seconde.

Le module de traitement 22 acquiert pendant l'étape d'injection au moins une deuxième mesure d'énergie, en l'occurrence une seule deuxième mesure d'énergie.

L'étape d'injection débute donc au début de la troisième seconde après le début de la période de stabilité et s'achève à la fin de la troisième seconde.

Le module de traitement 22 va alors comparer la deuxième mesure d'énergie et la première valeur de stabilité pour évaluer la précision du dispositif de mesure.

Cependant, le module de traitement 22 va, préalablement à cette analyse, mettre en œuvre une phase de vérification destinée à vérifier qu'une différence entre la deuxième mesure d'énergie et la première valeur de stabilité est due uniquement à l'injection du courant de test (et non, par exemple, à une hausse de la consommation de l'installation 3) .

La phase de vérification est réalisée suite à l'étape d'injection et consiste à acquérir une troisième mesure d'énergie et une deuxième mesure de courant, et à vérifier une première condition de vérification, selon laquelle la troisième mesure d'énergie est sensiblement égale à la première valeur de stabilité, et une deuxième condition de vérification, selon laquelle la deuxième mesure de courant est sensiblement égale à la deuxième valeur de stabilité.

La phase de vérification dure donc une seconde, et débute au début de la quatrième seconde après le début de la période de stabilité.

Si les deux conditions de vérification sont vérifiées, cela signifie que l'énergie consommée réellement par l'installation 3 et le courant sont bien restés constants depuis le début de la période de stabilité, et donc que la hausse d'énergie consommée mesurée par le dispositif de mesure pendant la phase d'injection est bien due uniquement à l'injection du courant de test $I_{test}$.

Si les deux conditions de vérification sont vérifiées, le module de traitement 22 compare la deuxième mesure d'énergie (réalisée pendant l'injection) avec une somme de la première valeur de stabilité et d'une valeur prédéfinie correspondant à une hausse attendue de l'énergie consommée pendant la durée prédéfinie due à l'injection du courant de test.

Le module de traitement 22 évalue la précision du dispositif de mesure à partir de ladite comparaison : si la deuxième mesure d'énergie est égale précisément à la somme de la première valeur de stabilité et de la valeur prédéfinie, cela signifie que le dispositif de mesure est très précis.

La valeur prédéfinie est évaluée à partir de la durée prédéterminée, et à partir de l'amplitude (ici de l'amplitude crête) et de la fréquence du courant de test $I_{test}$.

Comme le courant de test a une amplitude crête de 1A et une fréquence de 2kHz, la valeur prédéfinie est égale, pour une tension efficace du réseau égale à 230V, à :

$$\frac{230}{\sqrt{2}} \ \text{W.s} = 162.635\text{W.s}.$$

La différence obtenue entre la deuxième mesure d'énergie et la somme de la première valeur de stabilité et de la valeur prédéfinie permet d'évaluer et de vérifier la précision du dispositif de mesure

Le module de traitement 22 transmet alors au SI, via le modem 11 et la communication CPL, un message contenant le résultat de la vérification de la précision du dispositif de mesure et, éventuellement, une alarme pour signaler une dérive ou tout autre problème de précision. Les couches applicatives DLMS ou COSEM sont avantageusement utilisées pour mettre en œuvre cette communication.

On constate que la mise en œuvre du procédé d'évaluation est très courte : 4 secondes environ suffisent pour évaluer et vérifier la précision du dispositif de mesure.

On note que la vérification peut être faite dans tous les cas de courants rencontrés : courants faibles, c'est-à-dire d'amplitude proche de 0A, courants moyens, c'est-à-dire d'amplitude égale à quelques A, et courants forts, c'est-à-dire d'amplitude supérieure à 20A.

On note aussi qu'il peut être pertinent de réaliser une calibration usine de l'injection du courant de test de 1A crête et 2KHz, pour ajuster les mesures en régime permanent.

Bien entendu, l'invention n'est pas limitée au mode de réalisation décrit mais englobe toute variante entrant dans le champ de l'invention telle que définie par les revendications.

La première grandeur électrique pourrait être un courant et la deuxième grandeur électrique une énergie consommée pendant une durée prédéfinie.

La première grandeur électrique et la deuxième grandeur électrique ne sont pas nécessairement une énergie consommée pendant une durée prédéfinie et un courant. L'une de ces grandeurs électriques pourrait être par exemple une puissance consommée.

Le procédé d'évaluation selon l'invention peut parfaitement être mis en œuvre en utilisant les mesures d'une seule première grandeur électrique. Dans l'exemple décrit ici, il n'est ainsi pas nécessaire d'utiliser les mesures de courant, qui sont utilisées principalement pour consolider la détection de la période de stabilité et améliorer la phase de vérification. Dans le cas où une seule première grandeur électrique est utilisée :

- seules les premières mesures de la première grandeur électrique sont acquises au cours de la phase préliminaire du procédé d'évaluation ;

- la période de stabilité est détectée lorsque la première condition de stabilité (uniquement) est vérifiée ;
- seule la troisième mesure de la première grandeur électrique est acquise au cours de la phase de vérification ;
- seule la première condition de vérification est vérifiée au cours de la phase de vérification.

Bien que le compteur présenté ici soit un compteur monophasé, l'invention s'applique bien sûr aussi à tout compteur polyphasé.

Le module de traitement, dans lequel est mis en œuvre le procédé d'évaluation, le module de mesure, le générateur de courant et le modem ne sont pas nécessairement des modules distincts et peuvent comprendre un ou plusieurs composants (logiciels ou matériels) en commun.

## Revendications

1. Procédé d'évaluation de la précision d'un dispositif de mesure d'un compteur électrique (1), le procédé d'évaluation étant mis en œuvre par et dans le compteur électrique (1) et comportant :

   - une phase préliminaire, comprenant les étapes d'acquérir des premières mesures d'une première grandeur électrique, et de détecter une période de stabilité au cours de laquelle la première grandeur électrique est stable ;
   - une phase de test, suivant la détection de la période de stabilité et comprenant les étapes d'injecter un courant de test ($I_{test}$) pendant une durée prédéterminée sur un conducteur (9b) du compteur électrique, et d'acquérir pendant l'étape d'injection au moins une deuxième mesure de la première grandeur électrique ;
   - une phase d'évaluation, comprenant les étapes de comparer la deuxième mesure de la première grandeur électrique avec une somme d'une première valeur de stabilité représentative de la première grandeur électrique au cours de la période de stabilité, et d'une valeur prédéfinie correspondant à une hausse attendue de la première grandeur électrique due à l'injection du courant de test ($I_{test}$), et d'évaluer la précision du dispositif de mesure à partir de ladite comparaison.

2. Procédé d'évaluation selon la revendication 1, dans lequel la valeur prédéfinie est évaluée à partir de la durée prédéterminée, d'une amplitude et d'une fréquence du courant de test ($I_{test}$).

3. Procédé d'évaluation selon l'une des revendications précédentes, dans lequel la période de stabilité est détectée lorsqu'au moins une première condition de stabilité est vérifiée, selon laquelle un nombre prédéterminé de premières mesures successives de la première grandeur électrique sont sensiblement égales.

4. Procédé d'évaluation selon l'une des revendications précédentes, comprenant en outre une phase de vérification, destinée à vérifier qu'une différence entre la deuxième mesure de la première grandeur électrique et la première valeur de stabilité est due uniquement à l'injection du courant de test.

5. Procédé d'évaluation selon la revendication 4, dans lequel la phase de vérification est réalisée suite à l'étape d'injection, et comprend les étapes d'acquérir une troisième mesure de la première grandeur électrique, et de vérifier au moins une première condition de vérification, selon laquelle la troisième mesure de la première grandeur électrique est sensiblement égale à la première valeur de stabilité.

6. Procédé d'évaluation selon l'une des revendications précédentes, dans lequel la première grandeur électrique est une énergie consommée pendant une durée prédéfinie.

7. Procédé d'évaluation selon l'une des revendications précédentes, dans lequel la phase préliminaire comprend aussi les étapes d'acquérir des premières mesures d'une deuxième grandeur électrique.

8. Procédé d'évaluation selon la revendication 7, dans lequel la période de stabilité est détectée lorsque la première grandeur électrique et la deuxième grandeur électrique sont stables.

9. Procédé d'évaluation selon les revendications 3 et 8, dans lequel la phase de stabilité est détectée lorsque la première condition de stabilité est vérifiée, et lorsqu'une deuxième condition de stabilité est vérifiée, selon laquelle un même nombre prédéterminé de premières mesures successives de la deuxième grandeur électrique sont sensiblement égales.

10. Procédé d'évaluation selon les revendications 5 et 7, dans lequel la phase de confirmation comprend aussi les étapes d'acquérir une deuxième mesure de la deuxième grandeur électrique, et de vérifier la première condition de vérification et une deuxième condition de vérification, selon laquelle la deuxième mesure de la deuxième grandeur électrique est sensiblement égale à une deuxième valeur de stabilité représentative d'une valeur de la deuxième grandeur électrique au cours de la période de stabilité.

11. Procédé d'évaluation selon l'une des revendications 7 à 10, dans lequel la deuxième grandeur électrique est un courant.

12. Procédé d'évaluation selon l'une des revendications précédentes, dans lequel une fréquence du courant de test est définie de sorte que ladite fréquence est comprise dans une bande de fréquence opérationnelle du dispositif de mesure tout en étant à l'extérieur d'une bande de fréquence utilisée pour une communication par courants porteurs en ligne mise en œuvre par le compteur électrique (1).

13. Procédé d'évaluation selon l'une des revendications précédentes, dans lequel une amplitude crête du courant de test est comprise entre 800mA et 1.2A, et dans lequel une fréquence du courant de test est comprise entre 1.6kHz et 2.4kHz.

14. Compteur électrique comportant un dispositif de mesure, un dispositif d'injection comprenant un générateur de courant (18), et un module de traitement (22) agencé pour mettre en œuvre le procédé d'évaluation selon l'une des revendications précédentes.

15. Compteur électrique selon la revendication 14, dans lequel le générateur de courant (18) est un miroir de courant intégrant un oscillateur réglé à une fréquence du courant de test.

16. Compteur électrique selon l'une des revendications 14 ou 15, dans lequel le générateur de courant (18) est relié au conducteur (9b) via une inductance (19) et un interrupteur (20) piloté par le module de traitement (22).

17. Compteur électrique selon la revendication 16, dans lequel une valeur de l'inductance (19) est comprise entre 64µH et 96µH.

18. Programme d'ordinateur comprenant des instructions qui conduisent le compteur électrique selon l'une des revendications 14 à 17 à exécuter les étapes du procédé d'évaluation selon l'une des revendications 1 à 13.

19. Support d'enregistrement lisible par ordinateur, sur lequel est enregistré le programme d'ordinateur selon la revendication 18.

## Patentansprüche

1. Evaluierungsverfahren zum Evaluieren der Genauigkeit einer Messvorrichtung eines Stromzählers (1), wobei das Evaluierungsverfahren von und in dem Stromzähler (1) durchgeführt wird und umfasst:

- eine vorbereitende Phase, umfassend die Schritte des Erfassens erster Messungen einer ersten elektrischen Größe und des Detektierens einer Stabilitätsperiode, während der die erste elektrische Größe stabil ist;
- eine Testphase, die auf die Detektion der Stabilitätsperiode folgt und die Schritte des Einspeisens eines Teststroms (I$_{test}$) für eine vorbestimmte Dauer in einen Leiter (9b) des Stromzählers und des Erfassens mindestens einer zweiten Messung der ersten elektrischen Größe während des Einspeisungsschrittes umfasst;
- eine Evaluierungsphase, umfassend die Schritte des Vergleichens der zweiten Messung der ersten elektrischen Größe mit einer Summe aus einem ersten Stabilitätswert, der repräsentativ für die erste elektrische Größe während der Stabilitätsperiode ist, und aus einem vordefinierten Wert, der einem erwarteten Anstieg der ersten elektrischen Größe aufgrund des Einspeisens des Teststroms (I$_{test}$) entspricht, und des Evaluierens der Genauigkeit der Messvorrichtung anhand des genannten Vergleichs.

2. Evaluierungsverfahren nach Anspruch 1, bei dem der vordefinierte Wert anhand der vorbestimmten Dauer, einer Amplitude und einer Frequenz des Teststroms (I$_{test}$) evaluiert wird.

3. Evaluierungsverfahren nach einem der vorhergehenden Ansprüche, bei dem die Stabilitätsperiode detektiert wird, wenn mindestens ein erster Stabilitätszustand verifiziert wird, gemäß dem eine vorbestimmte Anzahl von aufeinanderfolgenden ersten Messungen der ersten elektrischen Größe im Wesentlichen gleich sind.

4. Evaluierungsverfahren nach einem der vorhergehenden Ansprüche, ferner umfassend eine Verifikationsphase, die dazu bestimmt ist, zu verifizieren, ob eine Differenz zwischen der zweiten Messung der ersten elektrischen Größe und dem ersten Stabilitätswert nur auf die Einspeisung des Teststroms zurückzuführen ist.

5. Evaluierungsverfahren nach Anspruch 4, bei dem die Verifikationsphase nach dem Einspeisungsschritt erfolgt und die Schritte des Erfassens einer dritten Messung der ersten elektrischen Größe und des Verifizierens zumindest eines ersten Verifikationszustandes umfasst, gemäß dem die dritte Messung der ersten elektrischen Größe im Wesentlichen gleich dem ersten Stabilitätswert ist.

6. Evaluierungsverfahren nach einem der vorhergehenden Ansprüche, bei dem die erste elektrische Größe eine während einer vordefinierten Dauer verbrauchte Energie ist.

7. Evaluierungsverfahren nach einem der vorhergehenden Ansprüche, bei dem die vorbereitende Phase auch die Schritte des Erfassens von ersten Messungen einer zweiten elektrischen Größe umfasst.

8. Evaluierungsverfahren nach Anspruch 7, bei dem die Stabilitätsperiode detektiert wird, wenn die erste elektrische Größe und die zweite elektrische Größe stabil sind.

9. Evaluierungsverfahren nach den Ansprüchen 3 und 8, bei dem die Stabilitätsphase detektiert wird, wenn der erste Stabilitätszustand verifiziert wird und wenn ein zweiter Stabilitätszustand verifiziert wird, gemäß dem eine gleiche vorbestimmte Anzahl von aufeinanderfolgenden ersten Messungen der zweiten elektrischen Größe im Wesentlichen gleich sind.

10. Evaluierungsverfahren nach den Ansprüchen 5 und 7, bei dem die Bestätigungsphase ferner die Schritte des Erfassens einer zweiten Messung der zweiten elektrischen Größe und des Verifizierens des ersten Verifikationszustandes und eines zweiten Verifikationszustandes umfasst, gemäß dem die zweite Messung der zweiten elektrischen Größe im Wesentlichen gleich einem zweiten Stabilitätswert ist, der repräsentativ für einen Wert der zweiten elektrischen Größe während der Stabilitätsperiode ist.

11. Evaluierungsverfahren nach einem der Ansprüche 7 bis 10, bei dem die zweite elektrische Größe ein Strom ist.

12. Evaluierungsverfahren nach einem der vorhergehenden Ansprüche, bei dem eine Frequenz des Teststroms derart definiert ist, dass die genannte Frequenz in einem Betriebsfrequenzband der Messvorrichtung liegt, während sie außerhalb eines Frequenzbandes liegt, das für eine Kommunikation mittels Powerline Communication verwendet wird, die von dem Stromzähler (1) verwendet wird.

13. Evaluierungsverfahren nach einem der vorhergehenden Ansprüche, bei dem eine Spitzenamplitude des Teststroms zwischen 800 mA und 1,2 A liegt und bei dem eine Frequenz des Teststroms zwischen 1,6 kHz und 2,4 kHz liegt.

14. Stromzähler, umfassend eine Messvorrichtung, eine Einspeisungsvorrichtung, die einen Stromgenerator (18) umfasst, und ein Verarbeitungsmodul (22), das ausgebildet ist, das Evaluierungsverfahren nach einem der vorhergehenden Ansprüche durchzuführen.

15. Stromzähler nach Anspruch 14, bei dem der Stromgenerator (18) ein Stromspiegel ist, in dem ein Oszillator integriert ist, der auf eine Frequenz des Teststroms eingestellt ist.

**16.** Stromzähler nach einem der Ansprüche 14 oder 15, bei dem der Stromgenerator (18) mit dem Leiter (9b) über eine Induktivität (19) und einen Unterbrecher (20) verbunden ist, der von dem Verarbeitungsmodul (22) gesteuert wird.

**17.** Stromzähler nach Anspruch 16, bei dem ein Wert der Induktivität (19) zwischen 64 $\mu$H und 96 $\mu$H liegt.

**18.** Computerprogramm, umfassend Anweisungen, die den Stromzähler nach einem der Ansprüche 14 bis 17 veranlassen, die Schritte des Evaluierungsverfahrens nach einem der Ansprüche 1 bis 13 auszuführen.

**19.** Computerlesbarer Aufzeichnungsträger, auf dem das Computerprogramm nach Anspruch 18 gespeichert ist.

**Claims**

**1.** An evaluation method for evaluating the accuracy of a measurement device of an electricity meter (1), the evaluation method being performed by and in the electricity meter (1) and comprising:

• a preliminary stage comprising a step of acquiring first measurements of a first electrical magnitude, and a step of detecting a period of stability during which the first electrical magnitude is stable;
• a test stage following detection of the period of stability and comprising an injection step for injecting a test current ($I_{test}$) into a conductor (9b) of the electricity meter for a predetermined duration, and a step of acting during the injection step to acquire at least one second measurement of the first electrical magnitude;
• an evaluation stage comprising a step of comparing the second measurement of the first electrical magnitude with a sum of a first stability value representative of the first electrical magnitude during the period of stability plus a predefined value corresponding to an expected increase in the first electrical magnitude due to injecting the test current ($I_{test}$), and a step of evaluating the accuracy of the measurement device from said comparison.

**2.** An evaluation method according to claim 1, wherein the predefined value is evaluated on the basis of the predetermined duration and on the basis of an amplitude and of a frequency of the test current ($I_{test}$).

**3.** An evaluation method according to either preceding claim, wherein the period of stability is detected when at least one first stability condition is satisfied, namely that a predetermined number of successive first measurements of the first electrical magnitude are substantially equal.

**4.** An evaluation method according to any preceding claim, further comprising a verification stage for verifying whether the difference, if any, between the second measurement of the first electrical magnitude and the first stability value is due solely to injecting the test current.

**5.** An evaluation method according to claim 4, wherein the verification stage is performed after the injection step, and comprises a step of acquiring a third measurement of the first electrical magnitude, and a step of verifying at least one first verification condition, namely that the third measurement of the first electrical magnitude is substantially equal to the first stability value.

**6.** An evaluation method according to any preceding claim, wherein the first electrical magnitude is the energy consumed during a predefined duration.

**7.** An evaluation method according to any preceding claim, wherein the preliminary stage also comprises a step of acquiring first measurements of a second electrical magnitude.

**8.** An evaluation method according to claim 7, wherein the period of stability is detected whenever both the first electrical magnitude and the second electrical magnitude are stable.

**9.** An evaluation method according to claims 3 and 8, wherein the period of stability is detected whenever both the first stability condition is satisfied and also a second stability condition is satisfied, namely that a same predetermined number of successive first measurements of the second electrical magnitude are substantially equal.

**10.** An evaluation method according to claims 5 and 7, wherein the verification stage also comprises a step of acquiring a second measurement of the second electrical magnitude, and a step of verifying both the first verification condition and also a second verification condition, namely that the second measurement of the second electrical magnitude is substantially equal to a second stability value representative of a value for the second electrical magnitude during a period of stability.

**11.** An evaluation method according to any one of claims 7 to 10, wherein the second electrical magnitude is current.

**12.** An evaluation method according to any preceding claim, wherein the test current has a frequency defined in such a manner that said frequency lies within an operating frequency band of the measurement device while lying outside a frequency band used for powerline current communication performed by the electricity meter (1).

13. An evaluation method according to any preceding claim, wherein the test current has a peak amplitude lying in the range 800 mA to 1.2 A, and wherein the test current has a frequency lying in the range 1.6 kHz to 2.4 kHz.

14. An electricity meter including a measurement device, an injection device comprising a current generator (18), and a processor module (22) arranged to perform the evaluation method according to any preceding claim.

15. An electricity meter according to claim 14, wherein the current generator (18) is a current mirror incorporating an oscillator set to the frequency of the test current $I_{test}$.

16. An electricity meter according to claim 14 or claim 15, wherein the current generator (18) is connected to the conductor (9b) via an inductor (19) and a switch (20) controlled by the processor module (22).

17. An electricity meter according to claim 16, wherein the inductor (19) presents inductance lying in the range 64 $\mu$H to 96 $\mu$H.

18. A computer program including instructions for causing the electricity meter according to any one of claims 14 to 17 to execute the steps of the evaluation method according to any one of claims 1 to 13.

19. A computer-readable storage medium storing the computer program according to claim 18.

Fig. 1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2343561 A